# EUROPÄISCHE PATENTSCHRIFT

(11) **EP 3 966 584 B1**
(45) Veröffentlichungstag und Bekanntmachung des Hinweises auf die Patenterteilung: **17.04.2024**
(21) Anmeldenummer: 20712208.6
(22) Anmeldetag: 25.02.2020
(51) Int. Cl.: G01R 33/58

(54) **PRÜFKÖRPER ZUR ANALYSE UND ÜBERWACHUNG DER BILDQUALITÄT VON MR-TOMOGRAPHEN**
TEST BODY FOR ANALYSING AND MONITORING THE IMAGE QUALITY FROM MR TOMOGRAPHS
CORPS DE CONTRÔLE POUR L'ANALYSE ET LA SURVEILLANCE DE LA QUALITÉ D'IMAGE DE TOMOGRAPHES RM

(30) Priorität: 10.05.2019 DE 102019112313
(43) Veröffentlichungstag der Anmeldung: 16.03.2022
(73) Patentinhaber: MRI-STaR - Magnetic Resonance Institute for Safety, Technology and Research GmbH, 46236 Bottrop (DE)
(72) Erfinder: SCHAEFERS, Gregor, 46236 Bottrop (DE); SPRONK, Tobias, 45721 Haltern am See (DE)
(74) Vertreter: Schneiders & Behrendt Bochum
(86) Internationale Anmeldenummer: PCT/EP2020/054932
(87) Internationale Veröffentlichungsnummer: WO 2020/229003

(56) Entgegenhaltungen:
- CN-A- 107 544 041
- GB-A- 2 155 187
- KR-A- 20080 111 737

## Beschreibung

Die Erfindung betrifft einen neuartigen Prüfkörper, ein sogenanntes Phantom, zur Kalibrierung, Bildqualitätsanalyse und/oder Qualitätssicherung bei einem Magnetresonanztomographen.

Die Magnetresonanztomographie (nachfolgend kurz MRT), häufig auch als Kernspintomographie bezeichnet, ist ein bildgebendes Verfahren in der medizinischen Diagnostik. Sie beruht auf dem physikalischen Effekt der Kernspinresonanz und ermöglicht eine dreidimensionale Darstellung von Körperstrukturen einschließlich Geweben. Die dreidimensionale Darstellung ergibt sich dabei durch das Zusammenfügen einer Vielzahl virtueller Schnittbilder der zu untersuchenden Körperregion.

Vereinfacht ausgedrückt, nutzt die MRT zur Sichtbarmachung unterschiedlicher Gewebe und somit zur Darstellung unterschiedlicher Körperstrukturen und Organe letztendlich den Umstand aus, dass bestimmte Atomkerne, insbesondere die von Wasserstoffatomen, aufgrund ihrer Eigendrehung (dem sogenannten Kernspin) magnetisch und auch magnetisierbar sind. Durch das Anlegen eines hochfrequenten Wechselfeldes lassen sich diese Atomkerne nach erfolgter Magnetisierung aus ihrem statischen Gleichgewichtszustand "kippen". Diese gekippten Atomkerne induzieren nunmehr einen messbaren Strom. Nach Wegfall des hochfrequenten Wechselfeldes streben die gekippten Atomkerne in ihren statischen Gleichgewichtszustand zurück, was als Relaxation bezeichnet wird. Der zur Darstellung unterschiedlicher Strukturen und Gewebe benötigte Kontrast beruht darauf, dass die Relaxationszeiten verschiedener Gewebe unterschiedlich sind.

Magnetresonanztomographen (nachfolgend kurz MR-Tomographen) zur Durchführung einer MRT sind entsprechend hochkomplexe Instrumente. Die von ihnen erzeugten Bilder müssen so präzise wie möglich die wirklichen anatomischen Gegebenheiten des untersuchten Objekts abbilden. Insbesondere müssen technisch bedingte Artefakte in der Datenerzeugung und Bildgebung unbedingt vermieden werden, da diese möglicherweise zu Fehldiagnosen und in der Folge zu Fehlbehandlungen führen können.

Um die Gefahr solcher technisch bedingter Artefakte zu minimieren, müssen MR-Tomographen regelmäßig gewartet und gegebenenfalls kalibriert werden. Der derzeit bedeutendste Standard für ein solches Kalibrierungsverfahren ist die Norm IEC 62464-1 zur Bestimmung wesentlicher Bildqualitätsparameter.

Zu den sechs nach dieser Norm zu bestimmenden Parametern gehören das Signal-Rausch-Verhältnis, die Gleichförmigkeit, die Schichtdicke, Geisterartefakte, die geometrische Verzerrung und die räumliche Auflösung.

Zur Überprüfung und gegebenenfalls Kalibrierung dieser Parameter werden Prüfkörper, sogenannte Phantome, in den MR-Tomographen eingeführt. Entsprechende Phantome sind im Stand der Technik bekannt.

Bekannte Phantome umfassen in der Regel einen hohlzylindrischen, flüssigkeitsgefüllten Grundkörper mit einer Anzahl von Messhilfen.

### Bekannte Messhilfen umfassen

- hinsichtlich der Parameter T₁ (Längsrelaxationszeit), T₂ (Querrelaxationszeit) und der Protonendichte definierte Messflüssigkeiten zur Bestimmung bzw. Kalibrierung insbesondere der Parameter Signal-Rausch-Verhältnis, Gleichförmigkeit und Geisterartefakte;
- keilförmige Elemente zur Bestimmung bzw. Kalibrierung insbesondere des Parameters Schichtdicke;
- Markierungen bekannten Abstands zueinander zur Bestimmung bzw. Kalibrierung insbesondere des Parameters geometrische Verzerrung;
- kammförmige Elemente zur Bestimmung bzw. Kalibrierung insbesondere des Parameters räumliche Auflösung.

Nachteilig am Stand der Technik ist, dass zur vollständigen Bestimmung bzw. Kalibrierung der normativ geforderten Bildqualitätsparameter in der Regel mehrere, nämlich bis zu sechs verschiedene Phantome notwendig sind. Wünschenswert wäre jedoch eine möglichst geringe Anzahl von Phantomen gleich aus mehreren Gründen.

Zum einen aus Gründen der Kostenersparnis, die die Beschaffung und Lagerung bestenfalls nur noch eines einzigen Phantoms im Gegensatz zu einer Vielzahl von Phantomen mit sich bringt.

Zum anderen aus Gründen der Effizienz, denn jeder Schritt, der bei der Kalibrierung eingespart werden kann, reduziert die erforderliche Arbeitszeit.

Nicht zuletzt natürlich aus Gründen der Sicherheit, denn jeder Schritt, der bei der Kalibrierung eingespart werden kann, hilft auch die Fehlerquote zu reduzieren. So führt eine einfach durchzuführende Bestimmung sowie Kalibrierung der wesentlichen Bildqualitätsparameter zu weniger Fehlern in diesem Prozess und somit zu einer genaueren Bildgebung, Diagnose und letztendlich besseren Therapie.

Mit der Bereitstellung eines Phantoms, das einfacher in der Anwendung und zeitsparend bei der Bestimmung und/oder Kalibrierung der wesentlichen Bildqualitätsparameter anwendbar ist, können also Kosten eingespart sowie Fehlbedienungen und Arbeitszeiten reduziert und somit die Betriebszeit des MR-Tomographen erhöht werden. Letztendlich wird so die Zuverlässigkeit des MR-Tomographen ebenso erhöht wie auch seine möglichen Einsatzzeiten.

KR 2008 01117337 A offenbart ein Phantom zur Evaluierung der Leistung eines MR-Tomographens mit mindestens vier Ebenen, an denen verschiedene Messhilfen vorgesehen sind.

CN 107 544 041 A beschreibt ein weiteres Phantom zur Evaluierung der Leistung eines MR-Tomographens mit verschiedenen Testmodulen auf verschiedenen Ebenen.

GB 2 155 187 A beschreibt ein weiteres Phantom zur Evaluierung der Leistung eines MR-Tomographens mit verschiedenen Testmodulen, die auf verschiedenen Ebenen angeordnet sind.

Nachteilig am Stand der Technik ist auch, dass bekannte Phantome aus einer Vielzahl von Einzelteilen zusammengesetzt sind, deren Zusammenbau und Kalibrierung aufwändig und somit sowohl kosten- und zeitintensiv als auch fehleranfällig im Zusammenbau und in der Herstellung ist.

So stellen bekannte Phantome, die eine Bestimmung und/oder Kalibrierung von mehr als einem Parameter gleichzeitig erlauben, die entsprechenden Messhilfen in der Regel in Modulform bereit, wobei jede Messhilfe in einem eigenen Modul angeordnet ist. Ein solches bekanntes Phantom umfasst entsprechend eine bestimmte Anzahl von Modulen, von denen jedes einzeln angefertigt werden muss, was zeit- und arbeitsaufwändig und somit kostenintensiv und fehleranfällig ist.

Nicht zuletzt ist es eine wesentliche Voraussetzung für den Erfolg der Bestimmung und/oder Kalibrierung der wesentlichen Bildqualitätsparameter, dass das Phantom korrekt ausgerichtet in dem MR-Tomographen platziert wird. Bekannte Phantome bieten entsprechend Adapter an, die in der Regel universell für verschiedene Systeme genutzt werden können. Solche Universaladapter haben jedoch häufig den Nachteil, dass sie nicht die letztendlich notwendige Präzision liefern können. Dies ist der Kompromiss, den eine solche Lösung bezüglich ihrer Universalität eingehen muss.

Es ist daher Aufgabe der Erfindung, ein Phantom zur Verfügung zu stellen, das die erforderliche Bestimmung und/oder Kalibrierung der wesentlichen Bildqualitätsparameter in einem einzigen Phantom in möglichst wenigen und einfach durchzuführenden Schritten ermöglicht.

Zudem ist es Aufgabe der Erfindung, ein Phantom zur Verfügung zu stellen, das eine möglichst geringe Anzahl von Einzelelementen umfasst und somit kostengünstig und bereits bei der Produktion weniger anfällig gegenüber Fehlern beim Zusammenbau ist.

Ferner ist es Aufgabe der Erfindung, ein Mess- und Auswertungsverfahren zur Verfügung zu stellen, das einfach anzuwenden ist, eine bestmögliche Bestimmung und/oder Kalibrierung der wesentlichen Bildqualitätsparameter ermöglicht und fehlerunempfindlich ist.

Gelöst wird diese Aufgabe durch eine erfindungsgemäße Vorrichtung mit den Merkmalen des Anspruchs 1. Vorteilhafte Ausgestaltungen sind jeweils Gegenstand der abhängigen Ansprüche. Es ist darauf hinzuweisen, dass die in den Ansprüchen einzeln aufgeführten Merkmale auch in beliebiger und technologisch sinnvoller Weise miteinander kombiniert werden können und somit weitere Ausgestaltungen der Erfindung aufzeigen.

Ein erfindungsgemäßes Phantom umfasst einen Phantomkörper mit darin angeordneten Messhilfen. Der Phantomkörper ist vorzugsweise aus einem Material gefertigt, das eine schnelle optische Erfassung von Materialschäden sowohl an dem Körper als auch an den Messhilfen ermöglicht. Ein geeignetes Material ist beispielsweise Akrylglas. Der Phantomkörper umfasst vorzugsweise ein hohlzylinderförmiges Grundelement, an dessen oberen und unteren Ende jeweils eine Kopf- bzw. eine Bodenplatte vorgesehen sind, die das Grundelement zumindest flüssigkeitsdicht abschließen.

Die Größe des Phantoms entspricht vorzugsweise den jeweiligen normativen Anforderungen, beispielsweise der IEC 62464-1, wobei grundsätzlich ein kleines Gewicht bei gleichzeitig hoher Stabilität erreicht werden sollte. Selbstverständlich sind die Dimensionen des Phantomkörpers dabei zumindest so zu wählen, dass die vorgesehenen Messhilfen darin Platz finden.

Die Messhilfen sind derart in dem Phantomkörper zu positionieren, dass das Phantom pro zu vermessender Achse nur einmal in den MR-Tomographen eingeführt werden muss. Dies ist vorteilhaft, da durch das nur einmalige Einführen pro zu vermessender Achse Zeit eingespart und Fehlerquellen minimiert werden können. Die Dauer der Bestimmung und/oder Kalibrierung der wesentlichen Bildqualitätsparameter lässt sich somit nahezu auf die reine Scanzeit reduzieren.

Die verschiedenen Messhilfen sind hierzu in einzelnen Ebenen angeordnet, wobei die Ebenen vorzugsweise parallel zu der Kopf- und Bodenplatte innerhalb des Phantomkörpers angeordnet sind.

Unter dem Begriff "Ebene" ist in diesem Zusammenhang ein longitudinaler Abschnitt des Phantomkörpers zu verstehen, wobei der Phantomkörper selbst nicht als Teil der Ebene verstanden wird und jede Ebene im Wesentlichen nur eine Messhilfe umfasst.

Der Phantomkörper ist mit einer wässrigen Salzlösung als Messflüssigkeit gefüllt, die durch ihre spezielle Zusammensetzung die elektrischen Eigenschaften von Muskelgewebe simuliert. Eine bevorzugte Salzlösung umfasst insbesondere Kupfersulfat und Natriumchlorid. Die Lösung kann auf verschiedene Feldstärken ausgelegt sein, beispielsweise für MR-Tomographen mit einer Feldstärke von 1.5 T.

Zum Einfüllen, Ablassen oder Austauschen der Messflüssigkeit können entsprechende Zu- und/oder Ableitungen an dem Phantomkörper und dort insbesondere an der Kopf- und/oder Bodenplatte vorgesehen sein. An diesen Zu- und/oder Ableitungen können entsprechend geeignete Ventilelemente vorgesehen sein.

Ein erfindungsgemäßes Phantom umfasst weiterhin einen Zwischenboden mit einer Ober- und einer Unterseite, an dem bzw. in dem alle festen Messhilfen, also alle jene, die keine Messflüssigkeit sind, angeordnet sind. Dies sind keilförmige Elemente zur Bestimmung bzw. Kalibrierung insbesondere des Parameters Schichtdicke, Markierungen bekannten Abstands zueinander zur Bestimmung bzw. Kalibrierung insbesondere des Parameters geometrische Verzerrung und kammförmige Elemente zur Bestimmung bzw. Kalibrierung insbesondere des Parameters räumliche Auflösung.

Erfindungsgemäß sind auf der einen Seite des Zwischenbodens die keilförmigen Elemente vorgesehen und auf der anderen Seite des Zwischenbodens die kammförmigen Elemente. In dem Zwischenboden selbst sind Markierungen bekannten Abstands zueinander vorgesehen, insbesondere in der Form von senkrecht zu der Zwischenbodenebene angebrachten Löchern.

Der Zwischenboden ist innerhalb des Phantomkörpers vorzugsweise parallel zu Kopf- und Bodenplatte angeordnet. Insbesondere ist der Zwischenboden mit den Messhilfen zudem so innerhalb des Phantomkörpers angeordnet, dass sich zumindest in einer Ebene des Phantomkörpers nur Messflüssigkeit und keine festen Messhilfen befinden.

Der vorherigen Definition einer Ebene folgen, umfasst ein erfindungsgemäßes Phantom demnach einen Phantomkörper mit mindestens vier Ebenen.

Eine erste Ebene umfasst die definierte Messflüssigkeit, wobei insbesondere die Parameter T₁ (Längsrelaxationszeit), T₂ (Querrelaxationszeit) und Protonendichte bekannt sind. Bei der Messflüssigkeit handelt es sich vorzugsweise um eine Salzlösung mit Kupfersulfat und Natriumchlorid, die an die jeweilige Feldstärke der Testumgebung angepasst werden muss. Diese erste Ebene dient vor allem zur Bestimmung bzw. Kalibrierung des Signal-Rausch-Verhältnisse, der Gleichförmigkeit und von Geisterartefakten.

Eine zweite Ebene umfasst keilförmige Elemente zur Bestimmung bzw. Kalibrierung der Schichtdicke. Die keilförmigen Elemente sind vorzugsweise paarweise angeordnet, wobei die Einzelkeile eines Paares jeweils parallel zueinander angeordnet sind und die Spitze des einen Keils zur Basis des anderen Keils zeigt und umgekehrt. Sofern zwei oder mehrere Paare keilförmiger Elemente vorgesehen sind, so sind zumindest zwei dieser Paare in senkrecht zueinander stehender Anordnung vorgesehen.

Eine dritte Ebene umfasst Markierungen bekannten Abstands zueinander zur Bestimmung bzw. Kalibrierung der geometrischen Verzerrung. Die Markierungen sind vorzugsweise als Bohrungen vorgesehen, insbesondere als Bohrungen in den oder durch den Zwischenboden.

Eine vierte Ebene umfasst mindestens zwei kammförmige Elemente zur Bestimmung bzw. Kalibrierung der räumlichen Auflösung. Ein kammförmiges Element umfasst im Wesentlichen eine Basis mit senkrecht darauf stehenden und parallel zueinander ausgerichteten Lamellen. Die mindestens zwei kammförmigen Elemente sind so zueinander ausgerichtet, dass die Lamellen der beiden Elemente senkrecht zueinander stehen.

Die Messhilfen der zweiten, dritten und vierten Ebene sind wie zuvor beschrieben erfindungsgemäß an bzw. in dem Zwischenboden angeordnet bzw. mit diesem verbunden. Die dritte Ebene entspricht somit im Wesentlichen dem Zwischenboden mit den Markierungen bekannten Abstands.

Selbstredend werden alle Ebenen, die eine feste Messhilfe umfassen, auch durch die Messflüssigkeit aufgefüllt.

In einer besonders bevorzugten Ausführungsform umfasst das Phantom genau vier Ebenen, wobei die erste Ebene als Messhilfe allein die Messflüssigkeit bekannter Dichte umfasst, vorzugsweise eine Salzlösung mit Kupfersulfat und Natriumchlorid, zur Bestimmung bzw. Kalibrierung des Signal-Rausch-Verhältnisse, der Gleichförmigkeit und von Geisterartefakten.

Die zweite Ebene umfasst neben der Messflüssigkeit allein keilförmige Elemente zur Bestimmung bzw. Kalibrierung der Schichtdicke. Die keilförmigen Elemente sind vorzugsweise paarweise angeordnet, wobei die Einzelkeile eines Paares jeweils parallel zueinander angeordnet sind und die Spitze des einen Keils zur Basis des anderen Keils zeigt und umgekehrt. Bevorzugt sind zwei Paare keilförmiger Elemente vorgesehen, die in senkrecht zueinander angeordnet sind.

Die dritte Ebene umfasst neben der Messflüssigkeit allein den Zwischenboden mit Markierungen bekannten Abstands zueinander zur Bestimmung bzw. Kalibrierung der geometrischen Verzerrung. Die Markierungen sind als Bohrungen durch den Zwischenboden vorgesehen.

Eine vierte Ebene umfasst neben der Messflüssigkeit allein kammförmige Elemente zur Bestimmung bzw. Kalibrierung der räumlichen Auflösung. Ein kammförmiges Element umfasst im Wesentlichen eine Basis mit senkrecht darauf stehenden und parallel zueinander ausgerichteten Lamellen. Vorzugsweise sind zwei kammförmige Elemente so zueinander ausgerichtet, dass die Lamellen der beiden Elemente senkrecht zueinander stehen.

Selbstredend werden auch bei dieser Ausführungsform alle Ebenen, die eine feste Messhilfe umfassen, auch durch die Messflüssigkeit aufgefüllt.

Nicht zuletzt umfasst das erfindungsgemäße Phantom vorzugsweise eine Halterung, die individuell an den MR-Tomographen anzupassen ist, in dem das Phantom eingesetzt werden soll. Eine solche individuell angepasste Halterung ist vorteilhaft, da sie dem Anwender eine zeitaufwändige und fehleranfällige Positionierung und Ausrichtung des Phantoms erspart. Vielmehr garantiert eine individuell angepasste Halterung nicht nur eine schnelle und fehlerfreie Positionierung und Ausrichtung des Phantoms, sondern vielmehr auch die Wiederholbarkeit der Messung.

Die Erfindung sowie das technische Umfeld werden nachfolgend anhand der Figuren näher erläutert. Es ist darauf hinzuweisen, dass die Figuren eine besonders bevorzugte Ausführungsvariante der Erfindung zeigen. Die Erfindung ist jedoch nicht auf die gezeigte Ausführungsvariante beschränkt. Insbesondere umfasst die Erfindung, soweit es technisch sinnvoll ist, beliebige Kombinationen der technischen Merkmale, sofern die Kombination unter den Schutzumfang der Patentansprüche fällt.

Es zeigen:
- Fig. 1: eine seitliche Ansicht eines erfindungsgemäßen Phantoms;
- Fig. 2: eine perspektivische Ansicht der keilförmigen Messelementen sowie darunter eine schematische Aufsicht auf die Anordnung dieser Elemente in der Ebene;
- Fig. 3: eine perspektivische Ansicht der dritten Ebene mit Abstandsmarkierungen sowie darunter eine schematische Aufsicht auf die Anordnung der Markierungen in der Ebene;
- Fig. 4: eine perspektivische Ansicht der vierten Ebene mit kammförmigen Messelementen sowie darunter eine schematische Aufsicht auf die Anordnung dieser Elemente in der Ebene;
- Fig. 5: eine perspektivische Ansicht der Halterung sowie darunter die Anordnung des Phantoms mit der Halterung in der Röhre eines MR-Tomographen.

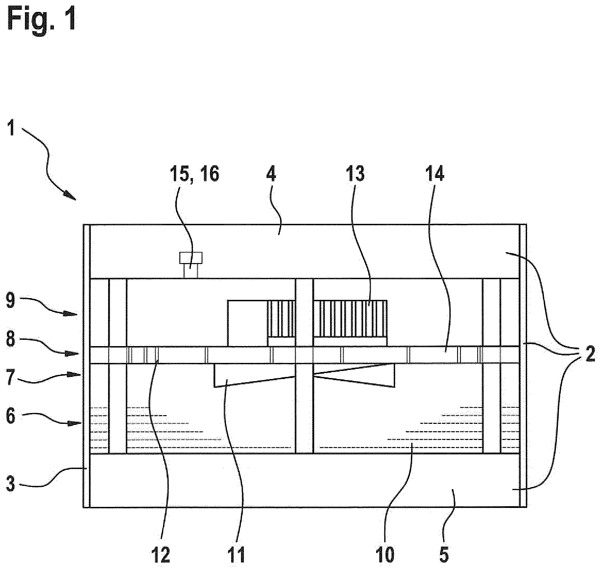

Fig. 1 zeigt ein erfindungsgemäßes Phantom 1 mit einem Phantomkörper 2, Messhilfen 10, 11, 12, 13 und einem Zwischenboden 14. Der Phantomkörper 2 umfasst einen hohlzylindrischen Grundkörper 3 sowie eine Kopfplatte 4 und eine Bodenplatte 5, die an den beiden Enden des hohlzylindrischen Grundkörpers 3 angeordnet sind. Die Kopfplatte 4 und die Bodenplatte 5 sind dabei parallel zueinander und senkrecht zu der Längsmittelachse des hohlzylindrischen Grundkörpers 3 angeordnet.

Die Kopfplatte 4 und die Bodenplatte 5 dichten den hohlzylindrischen Grundkörper 3 zumindest flüssigkeitsdicht ab. Zumindest der hohlzylindrische Grundkörper 3 ist vorzugsweise aus einem optisch durchsichtigen Material gefertigt, beispielsweise aus Acrylglas, sodass Beschädigungen des Phantoms 1 optisch wahrnehmbar sind.

Die Messhilfen 10, 11, 12, 13 sowie der Zwischenboden 14 sind innerhalb des Phantomkörpers 2 angeordnet. Die Messflüssigkeit 10 füllt den Phantomkörper 2 nahezu vollständig aus. Die sonstigen Messhilfen 11, 12, 13 sind an bzw. in dem Zwischenboden 14 angeordnet.

Insgesamt erfolgt die Anordnung der Messhilfen in vier Ebenen 6, 7, 8, 9, die nacheinander und parallel entlang der Mittellängsachse des Phantomkörpers angeordnet sind. Dabei ist es selbstverständlich, dass die Messflüssigkeit 10 alle Ebenen 6, 7, 8, 9 durchdringt.

Die erste Ebene 6 umfasst als Messhilfe alleine die Messflüssigkeit 10. Die zweite Ebene 7 umfasst als Messhilfe keilförmige Elemente 11. Die dritte Ebene 8 umfasst als Messhilfe Markierungen 12, die vorzugsweise an oder in dem Zwischenboden 14 angeordnet sind. Die vierte Ebene 9 umfasst als Messhilfe kammartige Elemente 13. Erfindungsgemäß sind die keilförmigen Elemente 11, die Markierungen 12 und die kammartigen Elemente 13 an oder in dem Zwischenboden 14 angeordnet.

Um einen Austausch der Messflüssigkeit 10 zu ermöglichen, sind in der Kopfplatte 4 und/oder in der Bodenplatte 5 optional Öffnungen 15 vorgesehen, durch die die Messflüssigkeit 10 zu- oder abgeleitet werden kann. Optionale Ventilelemente 16 können die Dichtigkeit des Phantoms 1 an diesen Stellen erhöhen.

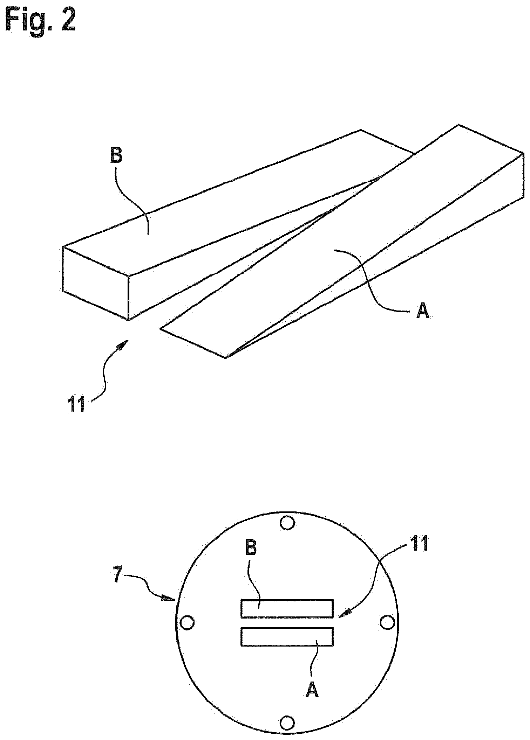

Fig. 2 zeigt im Detail die keilförmigen Elemente 11 der zweiten Ebene 7. Vorzugsweise sind die keilförmigen Elemente 11 von gleicher Größe und paarweise angeordnet mit einem ersten keilförmigen Element 11A und einem zweiten keilförmigen Element 11B. Die Einzelkeile 11A, 11B eines Paares 11 sind jeweils parallel zueinander angeordnet, wobei die Spitze des einen Keils 11A zur Basis des anderen Keils 11B zeigt und umgekehrt. Insbesondere endet die Spitze des einen Keils 11A an der Basis des anderen Keils 11B und umgekehrt. Sofern zwei Paare keilförmiger Elemente 11 vorgesehen, so sind diese vorzugsweise senkrecht zueinander angeordnet. Die keilförmigen Elemente 11 dienen zur Bestimmung bzw. Kalibrierung der Schichtdicke.

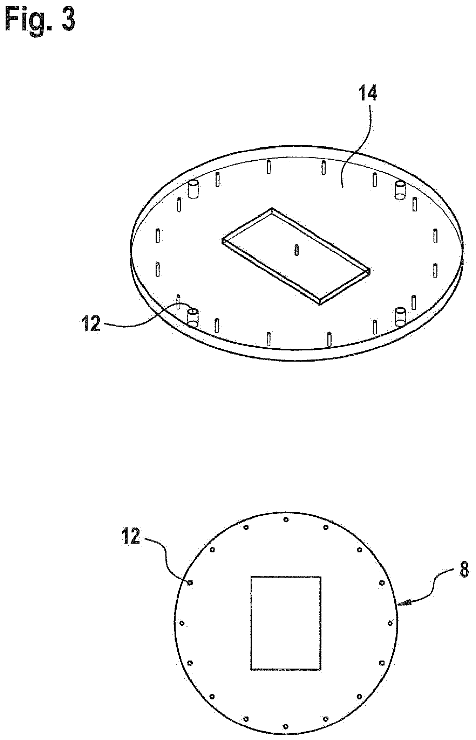

Fig. 3 zeigt im Detail die dritte Ebene 8 mit dem Zwischenboden 14 und den daran angeordneten Markierungen 12. Vorzugsweise sind die Markierungen 12 als senkrechte Bohrungen durch den Zwischenboden 14 vorgesehen. Die Markierungen 12 bekannten Abstands zueinander dienen zur Bestimmung bzw. Kalibrierung der geometrischen Verzerrung. Das in Fig. 3 beispielhaft gezeigte Verteilungsmuster dieser Markierungen 12 kann den jeweils geltenden normativen Anforderungen angepasst werden.

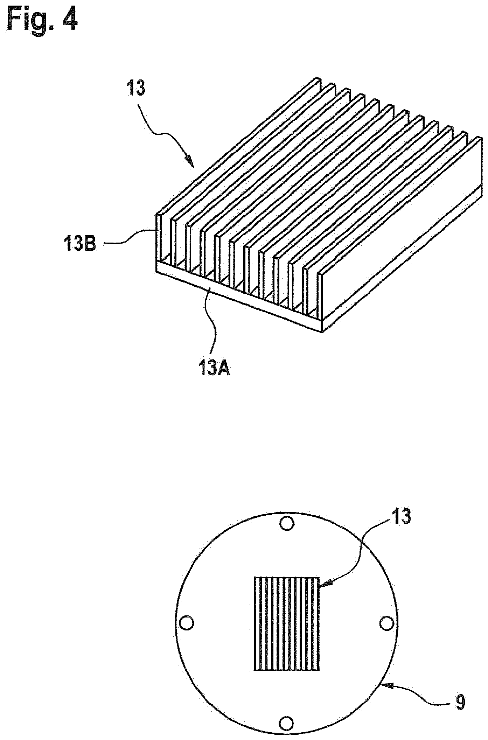

Fig. 4 zeigt im Detail die kammförmigen Elemente 13 der vierten Ebene 9 im Detail sowie in Aufsicht eine bevorzugte Anordnung. Die kammförmigen Elemente 13 umfassen eine Basis 13A und senkrecht auf der Basis angeordnete, parallel zueinander ausgerichtete Lamellen 13B. Die kammförmigen Elemente 13 dienen zur Bestimmung bzw. Kalibrierung der räumlichen Auflösung. Sofern zwei kammförmige Elemente 13 in der vierten Ebene 9 vorgesehen sind, sind diese so zueinander ausgerichtet, dass die Lamellen 13B der beiden Elemente 13 senkrecht zueinander angeordnet sind.

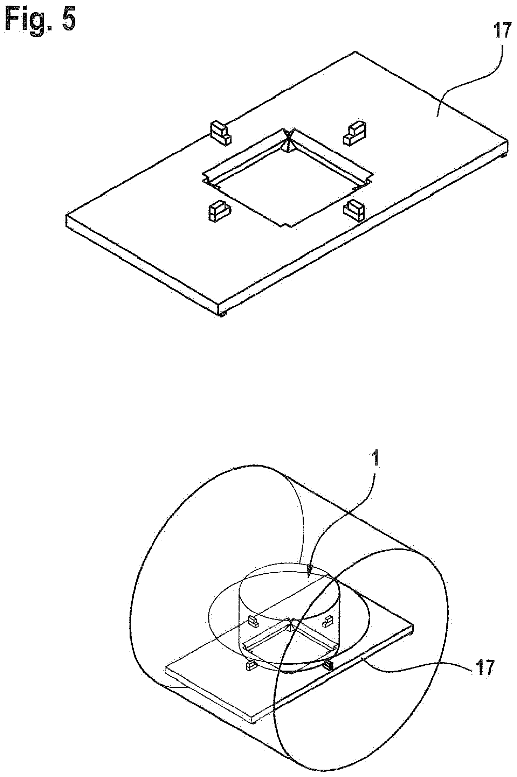

Fig. 5 zeigt eine schematische Darstellung der Halterung 17 zur Aufnahme des Phantoms 1. Die Halterung 17 gewährleistet neben der sicheren Aufnahme des Phantoms 1 auch die Reproduzierbarkeit der durchzuführenden Wartungsarbeiten. Durch die Passgenauigkeit der Halterung 17 ist nämlich gewährleistet, dass auch das Phantom 1 bei jeder neu durchzuführenden Wartung, nämlich einer Kalibrierung oder einer Bestimmung der wesentlichen Bildqualitätsparameter, exakt in der gleichen Position wie bei der letzten Wartung in dem MR-Tomographen angeordnet sein wird.

### Bezuaszeichenliste

- 1: Phantom
- 2: Phantomkörper
- 3: Grundelement
- 4: Kopfplatte
- 5: Bodenplatte
- 6: erste Ebene
- 7: zweite Ebene
- 8: dritte Ebene
- 9: vierte Ebene
- 10: Messflüssigkeit
- 11: keilförmige Elemente (A, B Einzelkeile)
- 12: Markierungen
- 13: kammförmige Elemente (13A Basis, 13B Lamellen)
- 14: Zwischenboden
- 15: Zu- oder Ableitung
- 16: Ventilelement
- 17: Halterung

## Patentansprüche

1. Phantom zur Verwendung in einem MR-Tomographen, mit einem mit einer Messflüssigkeit gefüllten Phantomkörper (2), Messhilfen (10, 11, 12, 13) und einem Zwischenboden (14) mit einer Ober- und einer Unterseite, wobei die Messhilfen (10, 11, 12, 13) und der Zwischenboden (14) in dem Phantomkörper (2) in mindestens vier Ebenen (6, 7, 8, 9) angeordnet sind, wobei
- eine erste Ebene (6) als Messhilfe allein die Messflüssigkeit (10);
- eine zweite Ebene (7) als Messhilfe keilförmige Elemente (11);
- eine dritte Ebene (8) als Messhilfe Markierungen (12) bekannten Abstands; und
- eine vierte Ebene (9) als Messhilfe kammförmige Elemente (13) umfasst,
**dadurch gekennzeichnet, dass** die Messhilfen (11) der zweiten Ebene (7) an der einen Seite des Zwischenbodens (14), die Messhilfen (13) der vierten Ebene (9) an der anderen Seite des Zwischenbodens (14) und die Messhilfen (12) der dritten Ebene (8) in dem Zwischenboden (14) angeordnet sind.

2. Phantom nach Anspruch 1, **dadurch gekennzeichnet, dass** der Phantomkörper (2) ein hohlzylinderförmiges Grundelement (3) umfasst, das am oberen und unteren Ende mit zumindest einer Kopf- und einer Bodenplatte (4, 5) abgeschlossen ist.

3. Phantom nach Anspruch 1 oder 2, **dadurch gekennzeichnet, dass** der Zwischenboden (14) parallel zu der Kopf- bzw. Bodenplatte (4, 5) angeordnet ist.

4. Phantom nach einem der vorherigen Ansprüche, **dadurch gekennzeichnet, dass** die als Messhilfen vorgesehenen keilförmigen Elemente (11) einer zweiten Ebene (7) paarweise angeordnet sind, wobei die Einzelkeile (11A, 11B) eines Paares jeweils parallel zueinander angeordnet sind und die Spitze des einen Keils (11A) zur Basis des anderen Keils (11B) zeigt und umgekehrt.

5. Phantom nach einem der vorherigen Ansprüche, **dadurch gekennzeichnet, dass** die als Messhilfen vorgesehenen Markierungen (12) einer dritten Ebene (8) als Bohrungen in dem Zwischenboden (14) vorgesehen sind.

6. Phantom nach einem der vorherigen Ansprüche, **dadurch gekennzeichnet, dass** die kammförmigen Elemente (13) eine Basis (13A) mit senkrecht darauf stehenden und parallel zueinander ausgerichteten Lamellen (13B) umfassen und zumindest zwei der als Messhilfen vorgesehenen kammförmigen Elemente (13) einer vierten Ebene (9) so zueinander ausgerichtet sind, dass die Lamellen (13B) der beiden kammförmigen Elemente (13) senkrecht zueinander ausgerichtet sind.

7. Phantom nach einem der vorherigen Ansprüche, **dadurch gekennzeichnet, dass** die Messflüssigkeit (10) eine Salzlösung mit Kupfersulfat und Natriumchlorid umfasst.

8. Phantom nach einem der vorherigen Ansprüche, **dadurch gekennzeichnet, dass** der Phantomkörper (1) im Wesentlichen aus Acrylglas gefertigt ist.

9. Phantom nach einem der vorherigen Ansprüche, **dadurch gekennzeichnet, dass** an dem Phantomkörper (2), insbesondere an der Kopf- und/oder Bodenplatte (4, 5), Zu- und/oder Ableitungen (15) für die Messflüssigkeit vorgesehen sind.

10. Phantom nach Anspruch 9, **dadurch gekennzeichnet, dass** an diesen Zu- und/oder Ableitungen (15) Ventilelemente (16) vorgesehen sind.

11. Phantom nach einem der vorherigen Ansprüche, **dadurch gekennzeichnet, dass** das Phantom (1) eine Halterung (17) umfasst, die individuell an einen MR-Tomographen angepasst ist.

## Claims

1. Phantom for use in an MR tomograph, with a phantom body (2) filled with a measuring liquid, measuring aids (10, 11, 12, 13) and an intermediate base (14) with an upper and a lower side, wherein the measuring aids (10, 11, 12, 13) and the intermediate base (14) are arranged in the phantom body (2) in at least four levels (6, 7, 8, 9), wherein
- a first level (6) comprises solely the measuring liquid (10) as a measuring aid;
- a second level (7) comprises wedge-shaped elements (11) as a measuring aid;
- a third level (8) comprises markings (12) of known distance as a measuring aid; and
- a fourth level (9) comprises comb-shaped elements (13) as a measuring aid,
**characterised in that** the measuring aids (11) of the second level (7) are arranged on one side of the intermediate base (14), the measuring aids (13) of the fourth level (9) are arranged on the other side of the intermediate base (14) and the measuring aids (12) of the third level (8) are arranged in the intermediate base (14).

2. Phantom according to claim 1, **characterised in that** the phantom body (2) comprises a basic element (3) in the form of a hollow cylinder, which element is closed at the upper and lower end by at least a head plate and a base plate (4, 5).

3. Phantom according to claim 1 or 2, **characterised in that** the intermediate base (14) is arranged parallel to the head plate or base plate (4, 5).

4. Phantom according to any one of the preceding claims, **characterised in that** the wedge-shaped elements (11) of a second level (7) provided as measuring aids are arranged in pairs, wherein the individual wedges (11A, 11B) of a pair are arranged respectively parallel to one another and the tip of one wedge (11A) points to the base of the other wedge (11B) and vice versa.

5. Phantom according to any one of the preceding claims, **characterised in that** the markings (12) of a third level (8) provided as measuring aids are provided as holes in the intermediate base (14).

6. Phantom according to any one of the preceding claims, **characterised in that** the comb-shaped elements (13) comprise a base (13A) with fins (13B) standing upright thereon and oriented parallel to one another and at least two of the comb-shaped elements (13) of a fourth level (9) provided as measuring aids are oriented to one another such that the fins (13B) of the two comb-shaped elements (13) are oriented perpendicular to one another.

7. Phantom according to any one of the preceding claims, **characterised in that** the measuring liquid (10) comprises a saline solution with copper sulphate and sodium chloride.

8. Phantom according to any one of the preceding claims, **characterised in that** the phantom body (1) is manufactured substantially from acrylic glass.

9. Phantom according to any one of the preceding claims, **characterised in that** supply and/or discharge lines (15) are provided on the phantom body (2), in particular on the head plate and/or base plate (4, 5), for the measuring liquid.

10. Phantom according to claim 9, **characterised in that** valve elements (16) are provided on these supply and/or discharge lines (15).

11. Phantom according to any one of the preceding claims, **characterised in that** the phantom (1) comprises a mounting (17), which is adapted individually to an MR tomograph.

## Revendications

1. Fantôme destiné à être utilisé dans un tomographe RM, avec un corps de fantôme (2) rempli d'un liquide de mesure, des auxiliaires de mesure (10, 11, 12, 13) et un fond intermédiaire (14) avec un côté supérieur et un côté inférieur, les auxiliaires de mesure (10, 11, 12, 13) et le fond intermédiaire (14) étant agencés dans le corps de fantôme (2) dans au moins quatre plans (6, 7, 8, 9),
- un premier plan (6) comprenant en tant qu'auxiliaire de mesure uniquement le liquide de mesure (10) ;
- un deuxième plan (7) comprenant en tant qu'auxiliaire de mesure des éléments cunéiformes (11) ;
- un troisième plan (8) comprenant en tant qu'auxiliaire de mesure des repères (12) de distance connue ; et
- un quatrième plan (9) comprenant en tant qu'auxiliaire de mesure des éléments en forme de peigne (13),
**caractérisé en ce que** les auxiliaires de mesure (11) du deuxième plan (7) sont agencés d'un côté du fond intermédiaire (14), les auxiliaires de mesure (13) du quatrième plan (9) sont agencés de l'autre côté du fond intermédiaire (14) et les auxiliaires de mesure (12) du troisième plan (8) sont agencées dans le fond intermédiaire (14).

2. Fantôme selon la revendication 1, **caractérisé en ce que** le corps de fantôme (2) comprend un élément de base (3) en forme de cylindre creux, qui est fermé aux extrémités supérieure et inférieure par au moins une plaque de tête et une plaque de fond (4, 5).

3. Fantôme selon la revendication 1 ou 2, **caractérisé en ce que** le fond intermédiaire (14) est agencé parallèlement à la plaque de tête et de fond (4, 5).

4. Fantôme selon l'une quelconque des revendications précédentes, **caractérisé en ce que** les éléments cunéiformes (11) d'un deuxième plan (7), prévus en tant qu'auxiliaires de mesure, sont agencés par paires, les coins individuels (11A, 11B) d'une paire étant agencés parallèlement l'un à l'autre et la pointe d'un coin (11A) étant dirigée vers la base de l'autre coin (11B) et inversement.

5. Fantôme selon l'une quelconque des revendications précédentes, **caractérisé en ce que** les repères (12) d'un troisième plan (8), prévus en tant qu'auxiliaires de mesure, sont prévus en tant qu'alésages dans le fond intermédiaire (14).

6. Fantôme selon l'une quelconque des revendications précédentes, **caractérisé en ce que** les éléments en forme de peigne (13) comprennent une base (13A) avec des lamelles (13B) perpendiculaires à celle-ci et orientées parallèlement les unes aux autres, et au moins deux des éléments en forme de peigne (13) d'un quatrième plan (9), prévus en tant qu'auxiliaires de mesure, sont orientés l'un par rapport à l'autre de telle sorte que les lamelles (13B) des deux éléments en forme de peigne (13) sont orientées perpendiculairement les unes aux autres.

7. Fantôme selon l'une quelconque des revendications précédentes, **caractérisé en ce que** le liquide de mesure (10) comprend une solution saline avec du sulfate de cuivre et du chlorure de sodium.

8. Fantôme selon l'une quelconque des revendications précédentes, **caractérisé en ce que** le corps de fantôme (1) est fabriqué essentiellement en verre acrylique.

9. Fantôme selon l'une quelconque des revendications précédentes, **caractérisé en ce que** des conduites d'alimentation et/ou d'évacuation (15) pour le liquide de mesure sont prévues sur le corps de fantôme (2), notamment sur la plaque de tête et/ou de fond (4, 5).

10. Fantôme selon la revendication 9, **caractérisé en ce que** des éléments de soupape (16) sont prévus sur ces conduites d'alimentation et/ou d'évacuation (15).

11. Fantôme selon l'une quelconque des revendications précédentes, **caractérisé en ce que** le fantôme (1) comprend un support (17) qui est adapté individuellement à un tomographe RM.
